**Europäisches Patentamt**

**European Patent Office**

**Office européen des brevets**

(19)

(11) **EP 1 178 320 B1**

(12) **EUROPEAN PATENT SPECIFICATION**

(45) Date of publication and mention
of the grant of the patent:
**20.04.2005 Bulletin 2005/16**

(51) Int Cl.$^7$: **G01R 1/067**, G01R 1/073

(21) Application number: **01118597.2**

(22) Date of filing: **02.08.2001**

(54) **Testing head having cantilever probes**

Prüfkopf mit freitragenden Auslegern

Tête de test avec sondes du type cantilever

(84) Designated Contracting States:
**DE FR GB**

(30) Priority: **04.08.2000 IT MI001834**

(43) Date of publication of application:
**06.02.2002 Bulletin 2002/06**

(73) Proprietor: **Technoprobe S.r.l**
**23870 Cernusco Lombardone (LC) (IT)**

(72) Inventors:
• **Felici, Stefano**
**23899 Robbiate (Lecco) (IT)**

• **Crippa, Giuseppe**
**23807 Merate (Lecco) (IT)**

(74) Representative: **Botti, Mario**
**Botti & Ferrari S.r.l.,**
**Via Locatelli, 5**
**20124 Milano (IT)**

(56) References cited:
**US-A- 4 480 223    US-A- 5 926 028**

• **PATENT ABSTRACTS OF JAPAN vol. 008, no.
226 (E-272), 17 October 1984 (1984-10-17) & JP
59 108324 A (MITSUBISHI DENKI KK), 22 June
1984 (1984-06-22)**

**EP 1 178 320 B1**

Note: Within nine months from the publication of the mention of the grant of the European patent, any person may give
notice to the European Patent Office of opposition to the European patent granted. Notice of opposition shall be filed in
a written reasoned statement. It shall not be deemed to have been filed until the opposition fee has been paid. (Art.
99(1) European Patent Convention).

## Description

<u>Field of Application</u>

The present invention relates to a testing head having cantilever probes.

Specifically, the invention relates to a testing head having cantilever probes, comprising at least one backing ring to which a resin holder is attached to hold a plurality of contact probes, the probes having a plurality of contact tips suitable to mechanically and electrically contact to a plurality of contact pads of at least one device to be tested.

The invention relates, particularly but not exclusively, to a testing head having cantilever probes, which is suitable for testing semiconductor integrated devices, this description making reference to this application field for convenience of illustration only.

<u>Prior Art</u>

As it is well known, a testing head is basically a device suitable to electrically interconnect a plurality of contact pads of a microstructure and the corresponding channels of a testing machine that is to perform the tests.

Integrated circuits are factory tested in order to spot and reject any circuits which are already defective during the production phase. The testing heads are normally employed to electrically test the integrated circuits "on wafer", prior to cutting and mounting them in a chip package.

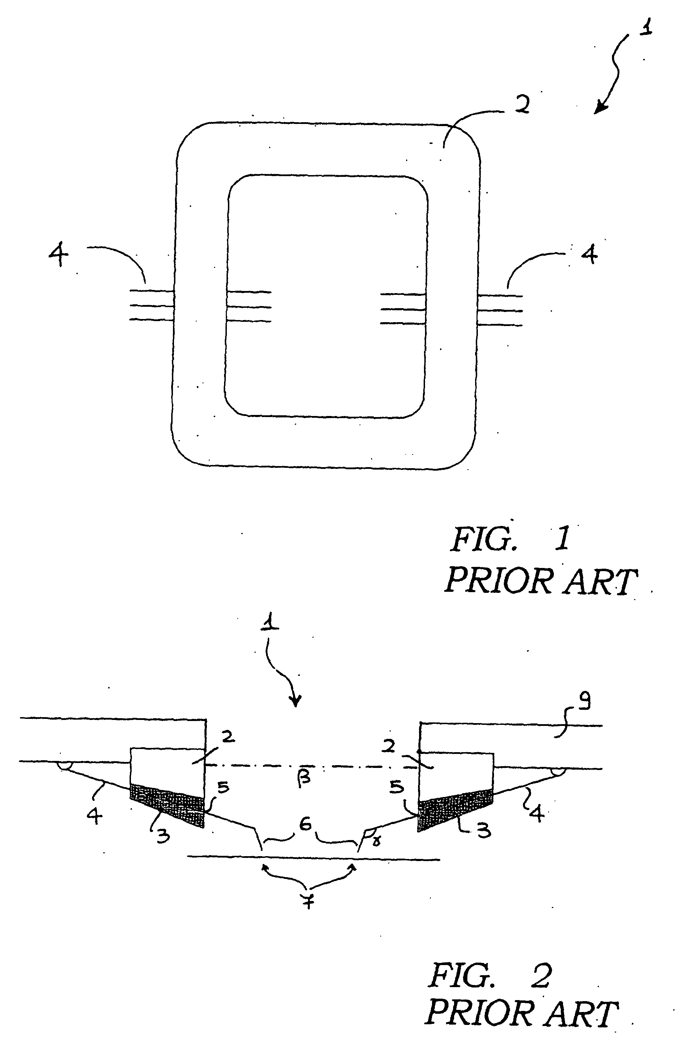

As schematically shown in Figures 1 and 2, a testing head 1 having cantilever probes usually comprises a backing ring 2, made of aluminium or ceramics, to which a resin holder 3 is attached, and that is suitable to hold a plurality of movable contact elements or probes 4, being normally wires made of special alloys having good electrical and mechanical properties, the probes being mounted to jut out of the resin holder 3 at plural points 5 and at a suitable angle from a plane β. Such emerging probes are commonly known as "cantilever probes".

In particular, each probe 4 has an end portion or contact tip 6, which is bent with an angle γ from the rest of the probe so that a plurality of contact pads 7 of a device to be tested is contacted. The bent contact tips 6 are commonly referred to as the "crooks".

The good connection of the probes 4 of the testing head 1 to the contact pads 7 of a device to be tested is ensured by the testing head 1 exerting a pressure on the device, whereby the probes 4 are vertically flexed in the opposite direction from the device movement towards the testing head 1.

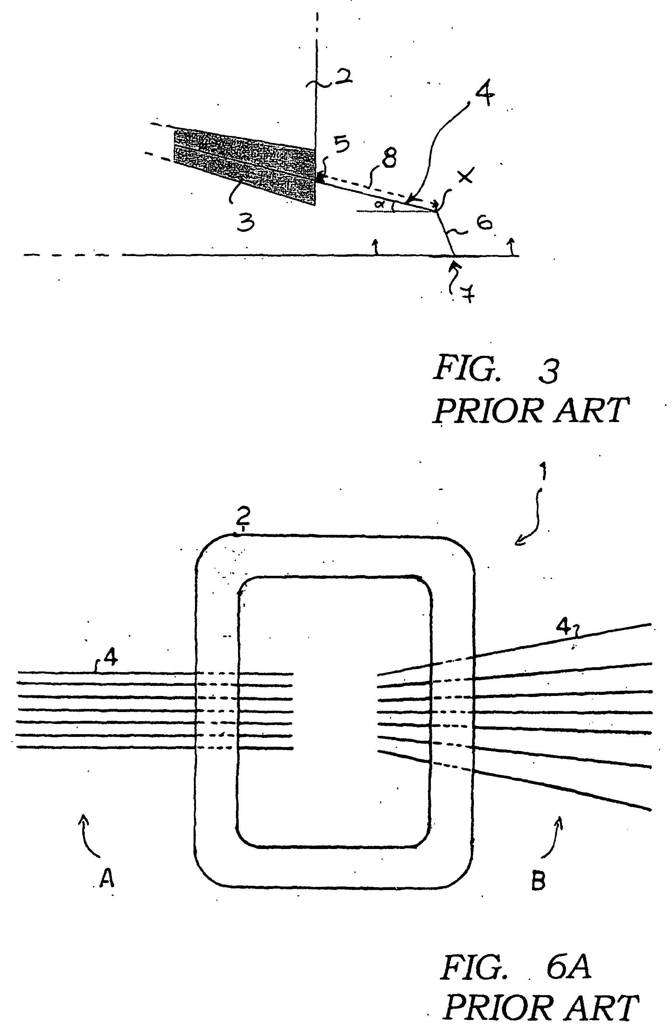

As schematically shown in Figure 3 for a single probe 4, as the device to be tested vertically moves against the contact tip 6, the probe 4 flexes, and its elbow point X, situated at the transition from the contact tip 6 to a probe section 8 emerging from the resin holder 3, describes a circular arc.

Thus, the jutting probe section 8 forms a working arm of the probe 4 adapted to flex vertically, and is commonly referred to as the "free length" of the probe.

The crooked shape of the probes 4 is designed to allow the contact tips 6 of the probes 4 to skid, upon coming in touch with the contact pads 7 of the device to be tested and during the pad overtravel beyond a preset point of contact, across the contact pads 7 along a direction dictated by the arrangement geometry.

It should be noted that the force exerted on the contact pads 7 by each probe 4 depends on many factors, among which are especially the type of material forming the probe 4, the probe shape, the angle a made by the probe contact tip 6, the length of the probe jutting section or free length 8, and the amount of overtravel of the pads to be measured. These factors also determine the extent of the contact tips 6 skidding on the contact pads 7, this being commonly known as the "scrub".

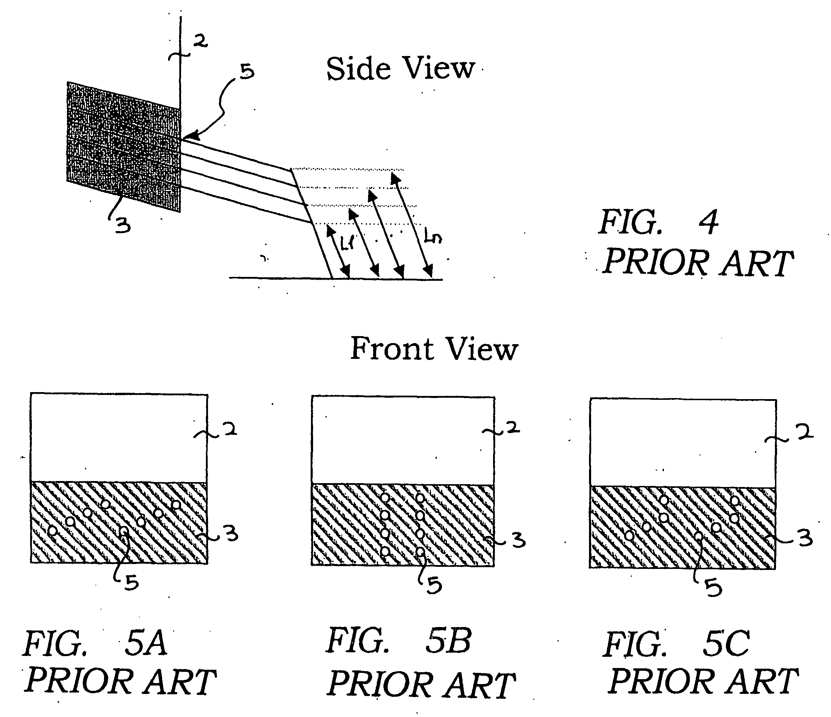

It should be noted that, with a dense distribution of the contact pads 7, the probes 4 must be arranged in plural rows, and the lengths L1,..., Ln of the crooked ends vary accordingly, as schematically shown in Figure 4.

Also known is to use backing rings 2, generally made of aluminium or ceramics, having different shapes depending on the set of contact pads 7 to be tested, so that the free lengths of the probes 4, and hence the forces exerted by the latter to the contact pads 7, can be equalised in the interest of even wear and performance of the testing head 1.

In particular, when the probes 4 are arranged in a plurality of rows or levels, as schematically shown in Figures 5A, 5B and 5C, the emerging points 5 of the probes 4 from the resin 3, when viewed frontally, make either a diagonal (Figure 5A), or straight (Figure 5B), or combination pattern (Figure 5C) that is dependent on constructional requirements.

The portions of the probes outside the backing ring 2 are usually soldered on a PC board 9, as shown in Figure 1, to establish an electrical connection between the testing head 1 having cantilever probes and the testing machine.

It is therefore necessary that the outer portion of any probe 4 can be recognised unfailingly in the probe bunch, so that it can be soldered on the PC board 9 in the correct manner.

In addition, the probes 4 extend with their sections outside the backing ring 2 parallel to one another, as shown in Figure 6A (side A), and the probes 4 for soldering on the PC board 9 are not easily singled out. It is also known the use of probes 4 with a radial spreading in their portion outside the backing ring 2, as schematically shown in Figure 6A (side B).

The probes 4 can be arranged in a plurality of rows or layers such that they have a diagonal or a straight configuration, in either the case of parallel or radial probes, as shown in Figure 6A.

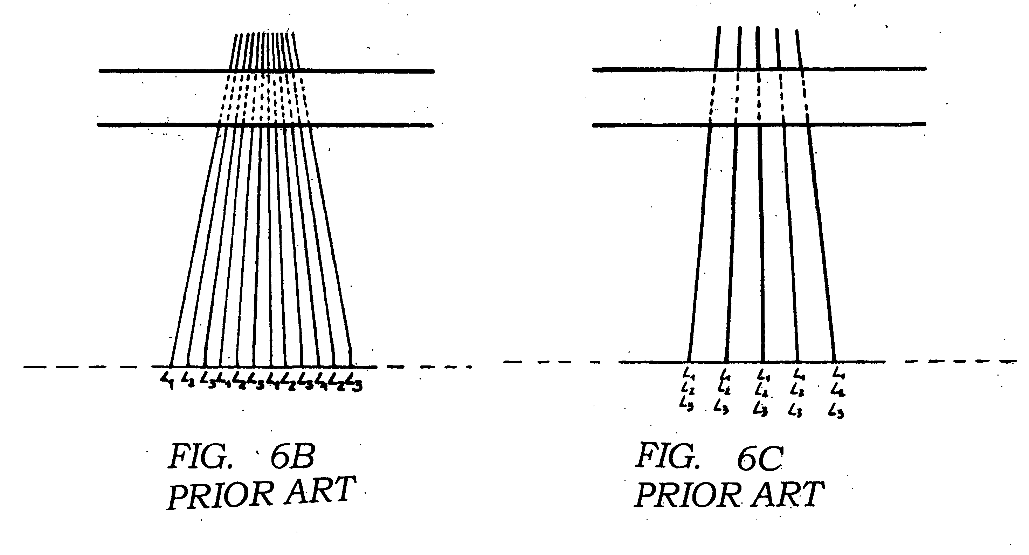

Figure 6B shows, by way of example, an arrangement of the probes 4 in three rows with a radial diagonal configuration, and Figure 6C shows an arrangement of the probes 4 in three rows with a radial straight configuration.

It is, moreover, a known fact that certain electronic devices, e.g. memories, have contact pads disposed along two sides only. Accordingly, a number of such devices can be tested in parallel if they are set in a single row.

A row of devices can be tested by suitably calibrating the inside dimensions of the backing ring 2.

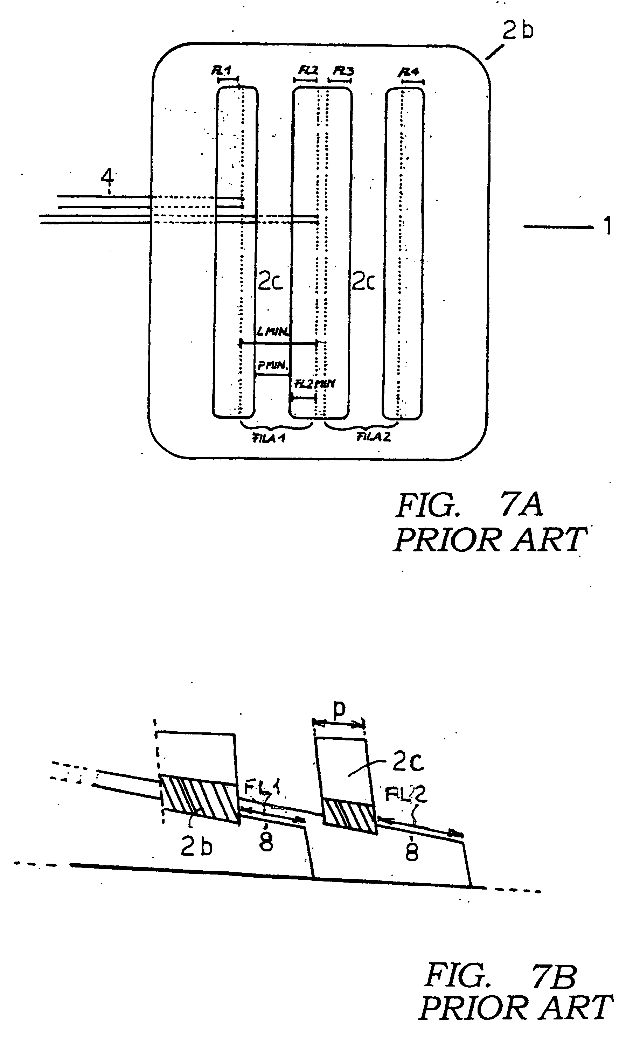

When several rows of devices are to be tested in parallel - usually two rows of eight devices or four rows of eight devices - multi-bridge backing rings, schematically shown in Figures 7A and 7B, are used.

In particular, a multi-bridge backing ring 2b includes a plurality of bridges 2c having a width dimension P inside the ring 2b perimeter, which bridges are suitable to carry probes for several devices to be tested in parallel. There are various techniques that can be used in order to obtain the desired pressure uniformity on the probes 4 against the corresponding contact pads 7.

A first known technique uses a multi-bridge backing ring 2b having plural bridges 2c inside its perimeter to define plural device rows FILA1, FILA2,... as schematically shown in Figures 7A and 7B.

The shape and dimensions of the multi-bridge backing ring 2b and the inner bridges 2c are selected such that the jutting sections or free lengths FL1, FL2, FL3, FL4,... of all the probes will be equalised. In this way, the probes 4 are all caused to abut on the contact pads 7 with the same force.

Probe cards of this known type are described in the US Patents No. 5,926,028 to Mochizuki and No. 4,480,223 to Aigo as well as in the Patent Abstract of Japan No. 59108324 in the name of Mitsubishi Electric Corp..

A limitation comes to this prior technique from that the minimum width Lmin of a device to be tested cannot be less than the sum of the minimum length FLmin of the jutting section or minimum free length FL1, FL2,... of the probes 4 and the minimum theoretical width Pmin of each inner bridge 2c, i.e.:

$$Lmin \geq FLmin + Pmin, \qquad (1)$$

as schematically shown in Figure 7A.

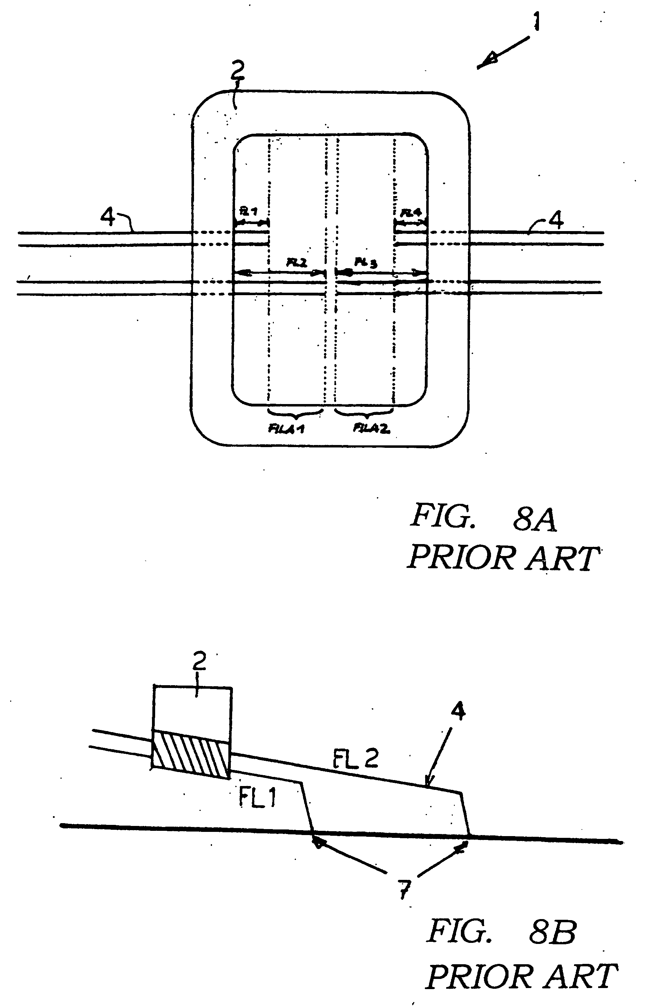

A second prior technique uses probes of different types bound to the same backing ring 2, as schematically shown in Figures 8A and 8B.

In particular, probes 4 of a larger diameter are used for the innermost contact pads 7 within the backing ring perimeter, to have equal forces exerted on the contact pads 7 even though the jutting sections or free lengths FL1, FL2,... may be different.

Using this technique, however, the dimensions and free lengths of the probes 4 are difficult to calibrate for an even pressure on all the contact pads 7. In addition, the probes 4 which are to reach devices located farther inwards than the probe emergence points on the backing ring 2 will be those having the largest dimensions, as having the greatest jutting sections or free lengths 8, thus enforcing reduced density for the contact pads 7 on the devices.

Also, neither of the above prior techniques would work where a large number of devices are to be tested in parallel. In particular, the testing heads so provided cannot test more than two rows of devices, and are definitely incapable of testing a matrix array of devices.

The technical problem underlying this invention is to provide a testing head for microstructures, have a configuration which can facilitate the operations of sorting out probes and soldering them on a PC board, specifically densely clustered probes, and allows an unlimited number of devices laid into plural rows to be tested.

## Summary of the Invention

The principle on which this invention stands is one of suitably shaping the resin holder attached to the probe backing ring in order to provide a clearer view of each probe in a cluster of probes during the soldering steps, while also maintaining an accurate control of the probe jutting sections or free lengths when a plurality of devices are under parallel test.

Based on the above principle, the technical problem is solved by a testing head as previously indicated being characterised in that the resin holder is formed with at least one suitably shaped outline in correspondence of the device side, in order to allow different probe rows to overhang in a cantilever fashion.

In particular, in the testing head according to the invention, the outline of the resin holder includes at least two steps with a shape such to allow different probe rows to emerge.

The features and advantages of a testing head according to the invention will become apparent from the following description of embodiments thereof, given by way of non-limiting examples with reference to the accompanying drawings.

## Brief Description of the Drawings

In the drawings:

- Figure 1 shows a top plan view of a testing head having cantilever probes, according to the prior art;

- Figure 2 shows a sectional view of the testing head having cantilever probes of Figure 1;

- Figure 3 shows a sectional view of a detail of the testing head having cantilever probes of Figure 1;

- Figure 4 shows a sectional view of a detail of a further embodiment of a testing head having cantilever probes according to the prior art;

- Figures 5A, 5B and 5C schematically show a sectional view of a detail of the testing head having cantilever probes of Figure 4;

- Figures 6A, 6B and 6C show schematic views of another embodiment of a testing head having cantilever probes according to the prior art;

- Figures 7A and 7B show schematic views of a further embodiment of a testing head having cantilever probes according to the prior art;

- Figures 8A and 8B show schematic views of another embodiment of a testing head having cantilever probes according to the prior art;

- Figure 9 schematically show a sectional view of a testing head having cantilever probes according to the invention;

- Figure 10 schematically shows a sectional view of a further embodiment of the testing head having cantilever probes of Figure 9; and

- Figure 11 schematically shows a sectional view of another embodiment of the testing head having cantilever probes according to the invention

Detailed Description

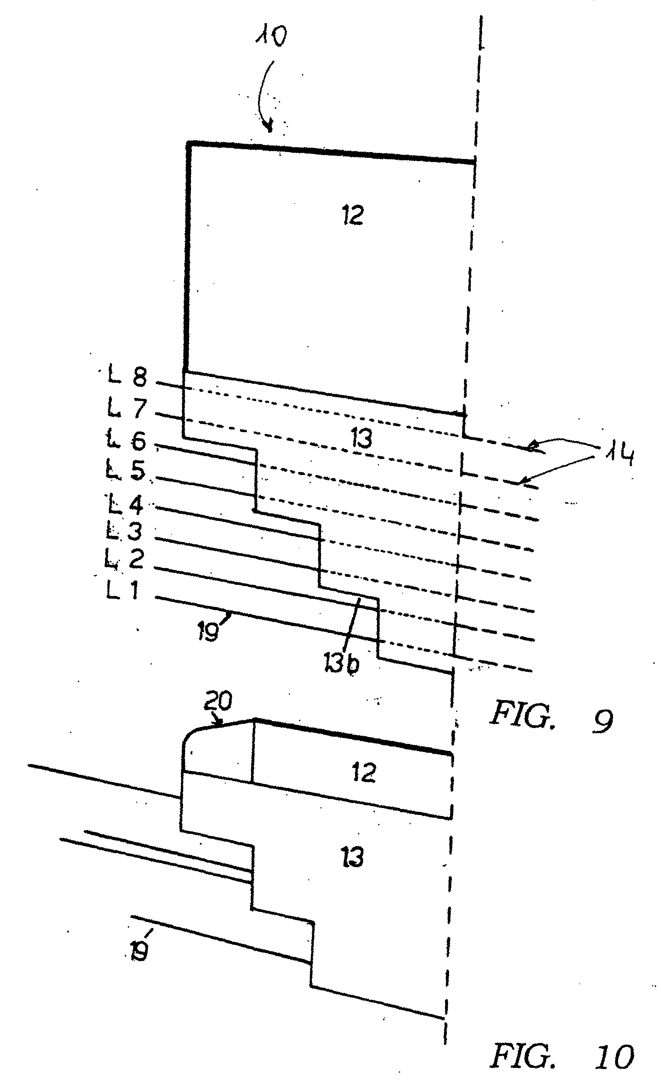

With reference in particular to Figure 9, a testing head 10 according to the invention, being employed to test at least one device, comprises at least one backing ring 12 having a resin holder 13 suitable to hold a plurality of probes 14.

The probes 14 are arranged in plural rows L1, L2,..., Ln in order to increase their density, it being possible for the probes to be laid in a pattern of either diagonal or straight or combination lines, depending on individual requirements.

Advantageously in the invention, the holder 13 has a suitably shaped outline 13b in correspondence of outer sections 19 of the probes 14, i.e. in correspondence of a region of a PC board (not shown) where the probes 14 are soldered on the board.

In particular, the outline 13b shows a plurality of steps helping the detection of specific probes within the bunch of probes that emerge from the resin holder 13, by virtue of the probe selection having been restricted to no more than one or a small number of probe rows.

In a preferred embodiment of the invention, the outline 13b includes a plurality of steps, all with the same width and height. In particular, the outline 13b has as many steps as many the rows of probes 14 are.

Alternatively, it would be possible to provide an outline 13b with a number of steps which is a submultiple of the number of rows, with each step defining points of emergence of more than one row of probes 14.

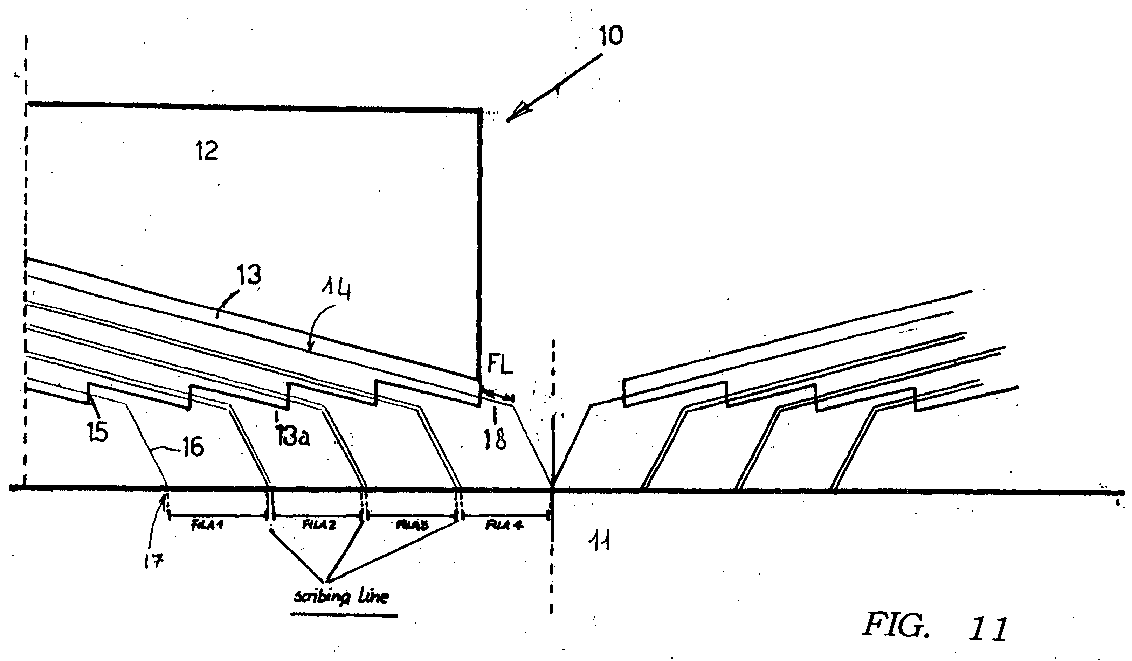

As shown by way of non-limiting example in Figure 11, assuming the probes 14 to be arranged in eight rows L1-L8, the outline 13b of the resin holder 13 would have four steps, with each step defining the points of emergence of two rows of probes 14.

The number of rows per step may be varied, even within the same testing head, to meet specific requirements. It should be noted that one probe row might include probes placed at different heights above the plane containing the plurality of devices 11 to be tested.

In this way, soldering an unlimited number of probes, in different rows, can be made easier by providing the outline 13b with an appropriate number of steps.

Advantageously in the invention, it would also be possible to use a resin holder 13 of a larger size than the backing ring 12, e.g. by adding final filling resin 20 to blend these elements to each other, as schematically shown in Figure 10.

Shown in Figure 11 is a further embodiment of the testing head 10 according to the invention. The testing head 10, for application to a plurality of devices 11 to be tested, comprises at least one backing ring 12 having a resin holder 13 for holding a plurality of probes 14.

In particular, the probes 14 have an end portion or contact tip 16 that is bent through a suitable angle from the probes to contact a plurality of contact pads 17 on said plurality of devices 11 to be tested.

Furthermore, the probes 14 are arranged in several rows L1, L2,..., Ln for increasing their density, the probe layout in front view being a pattern of diagonal or straight or combination lines, depending on individual requirements.

Good contacting of the contact pads 17 of the device to be tested by the probes 14 of the testing head 10 is conventionally ensured by the pressure of the testing head 10 on the device, the probes 14 vertically flexing in the opposite direction from the device direction of advance toward the testing head 10.

Advantageously according to the invention, the holder 13 has a suitably shaped outline 13a in correspondence of the jutting sections or free lengths 18 of the probes 14, i.e. in correspondence of the devices to be tested.

In particular, the outline 13a shows a plurality of steps having shape and dimensions suitably selected to ensure an even pressure of the probes 14 on the contact pads 17 as the devices to be tested are brought to contact the testing head 10.

In a preferred embodiment of the testing head 10, schematically shown in Figure 11, the holder 13 has a saw-tooth outline 13a, establishing a common level of emergence for said probes 14. In other words, the points 15 of emergence of the probes 14 from the resin holder 13 lie on a parallel plane to the plane containing the plurality of devices 11 to be tested, but are shifted in position from one another in order to reach contact pads 17 on different devices.

Advantageously according to the invention, the probes 14 have all jutting sections or free lengths 18 that jut equally out of the emergence points 15. Thus, a plurality of devices 11 laid in several parallel rows can be tested by using equally dimensioned probes formed out of the same materials, at the same time as the proper pressure can be maintained on the contact pads 17 of devices lying in different rows, as schematically shown in Figure 11.

It can be seen in Figure 11 that the probes in touch with pads located in adjacent device rows spaced a predetermined distance apart, known as the "scribing line", belong to different rows but to the same step. In this case, a variation in the jutting sections or free lengths 18 must be provided. However, this variation is far less than in conventional testing heads, and can be readily compensated by altering the probe dimensions, e.g. varying the shape of the probe tip.

In addition, the testing head 10 of this invention obviates the shortcomings of conventional testing heads having cantilever probes, and allows a matrix array of devices laid serially in plural rows to be tested.

In particular, the density of those probes 14 which are to test devices placed farther inwards of the backing ring 12 is the same as the density of the probes 14 used for testing devices placed next to the backing ring 12, thus providing for an equal density of contact pads 17 on the devices to be tested, regardless of their positions in a matrix array.

To summarise, the testing head 10 of this invention allows probes 14 of equal size and formed out of the same material to be used for testing a matrix array of devices having an unlimited number of rows and columns.

## Claims

1. A testing head (10) having cantilever probes, comprising at least one backing ring (12) to which a resin holder (13) is attached to hold a plurality of contact probes (14), the probes being formed with respective contact tips (16) suitable to mechanically and electrically contact to a plurality of contact pads (17) of at least one device (11) to be tested, said resin holder (13) being formed with at least one suitably shaped outline (13b) to allow different probe rows to emerge in a cantilever manner, said shaped outline of the resin holder (13) including at least two steps formed to allow at least two different rows of said contact probes (14) to emerge, **characterised in that** said shaped outline (13b) is provided in correspondence of an outer section (19) for soldering said contact probes (14).

2. A testing head (10) according to Claim 1, **characterised in that** each step of the shaped outline (13b) holds said contact probes (14) in a same row.

3. A testing head (10) according to Claim 1, **characterised in that** each step of the shaped outline (13b) holds said contact probes (14) in different rows.

4. A testing head (10) according to Claim 1, **characterised in that** said resin holder (13) comprises a further shaped outline (13a) which is positioned in correspondence of said device (11) to be tested.

5. A testing head (10) according to Claim 4, **characterised in that** said further shaped outline (13a) of the resin holder (13) is a saw-tooth outline, whereby the emerging points (15) of said contact probes (14) from said resin holder (13) lie on a parallel plane to the plane containing said device (11) to be tested.

6. A testing head (10) according to Claim 5, **characterised in that** said further shaped outline (13a) produces jutting sections (8) of said contact probes (14) from the resin holder (13) that are substantially identical with one another.

7. A testing head (10) according to any of Claims 1 to 6, **characterised in that** it comprises a plurality of said contact probes (14) arranged in rows to test a matrix array of devices serially laid in rows, each device (11) in said array being reached by said contact probes (14) of different rows.

8. A testing head (10) according to any of the preceding claims 1 to 7, **characterised in that** said holder (13) is larger than said backing ring (12).

9. A testing head (10) according to Claim 1, **characterised in that** a finishing filler resin (20) is used to blend together said resin holder (13) and said backing ring (12).

## Patentansprüche

1. Prüfkopf (10) mit einseitig eingespannten Tastköpfen, der zumindest einen Trägerring (12) umfasst, an dem eine Kunststoffhalterung (13) befestigt ist, um mehrere Kontakttastköpfe (14) zu halten, wobei die Tastköpfe mit jeweiligen Kontaktspitzen (16) ausgebildet sind, die dazu geeignet sind, mehrere Kontaktflecken (17) von zumindest einem zu prüfenden Bauelement (11) mechanisch und elektrisch zu kontaktieren, wobei die Kunststoffhalterung (13)

9       **EP 1 178 320 B1**       10

mit zumindest einer geeignet geformten Kontur (13b) ausgebildet ist, um das Hervortreten von verschiedenen Tastkopfreihen in einseitig eingespannter Art und Weise zu ermöglichen, wobei die geformte Kontur der Kunststoffhalterung (13) zumindest zwei Stufen umfasst, die so gebildet sind, dass mindestens zwei verschiedene Reihen der Kontakttastköpfe (14) hervortreten können, **dadurch gekennzeichnet, dass** die geformte Kontur (13b) entsprechend einem Außenabschnitt (19) zum Verlöten der Kontakttastköpfe (14) vorgesehen ist.

2. Prüfkopf (10) nach Anspruch 1, **dadurch gekennzeichnet, dass** jede Stufe der geformten Kontur (13b) Kontakttastköpfe (14) in derselben Reihe hält.

3. Prüfkopf (10) nach Anspruch 1, **dadurch gekennzeichnet, dass** jede Stufe der geformten Kontur (13b) Kontakttastköpfe (14) in verschiedenen Reihen hält.

4. Prüfkopf (10) nach Anspruch 1, **dadurch gekennzeichnet, dass** die Kunststoffhalterung (13) eine weitere geformte Kontur (13a) umfasst, die entsprechend dem zu prüfenden Bauelement (11) angeordnet ist.

5. Prüfkopf (10) nach Anspruch 4, **dadurch gekennzeichnet, dass** die weitere geformte Kontur (13a) der Kunststoffhalterung (13) eine sägezahnförmige Kontur ist, wodurch die aus der Kunststoffhalterung (13) heraustretenden Spitzen (15) der Kontakttastköpfe (14) auf einer Ebene liegen, die zu der das zu prüfende Bauelement (11) enthaltenden Ebene parallel ist.

6. Prüfkopf (10) nach Anspruch 5, **dadurch gekennzeichnet, dass** die weitere geformte Kontur (13a) über die Kunststoffhalterung (13) überstehende Abschnitte (8) der Kontakttastköpfe (14) hervorbringt, die im Wesentlichen einander gleich sind.

7. Prüfkopf (10) nach einem der Ansprüche 1 bis 6, **dadurch gekennzeichnet, dass** er mehrere in Reihen angeordnete Kontakttastköpfe (14) umfasst, um ein Matrixfeld aus Bauelementen zu prüfen, die nacheinander aufgereiht sind, wobei jedes Bauelement (11) in dem Feld von Kontakttastköpfen (14) aus verschiedenen Reihen erreicht wird.

8. Prüfkopf (10) nach einem der vorhergehenden Ansprüche 1 bis 7, **dadurch gekennzeichnet, dass** die Halterung (13) größer als der Trägerring (12) ist.

9. Prüfkopf (10) nach Anspruch 1, **dadurch gekennzeichnet, dass** ein abschließendes Füllharz (20) verwendet wird, um die Kunststoffhalterung (13) und den Trägerring (12) zusammenzuhalten.

**Revendications**

1. Tête d'essai (10) équipée de sondes en porte-à-faux, comprenant au moins un anneau de renforcement (12), auquel est attaché un support en résine (13) conçu pour retenir une pluralité de sondes de contacte (14), les sondes équipées de leurs extrémités de contacte respectives (16) étant capable de contacte mécanique et électrique avec une pluralité de pastilles de contacte (17), d'au moins un dispositif soumis à l'essai (11), ledit support de résine (13) étant équipé d'au moins un contour (13b) de forme correcte permettant à plusieurs rangées de sondes d'émerger en porte-à-faux, ledit contour du support en résine (13) comprenant au moins deux paliers permettant à au moins deux rangées différentes desdites sondes de contacte d'émerger, **caractérisée en ce que** ledit contour formé (13b) est fourni en correspondance avec une partie externe (19), destinée au soudage desdites sondes de contacte (14).

2. Tête d'essai (10) selon la revendication 1, **caractérisée en ce que** chaque pallier du contour formé (13b) retient lesdites sondes de contacte (14) sur une même rangée.

3. Tête d'essai (10) selon la revendication 1, **caractérisée en ce que** chaque pallier du contour formé (13b) retient lesdites sondes de contacte (14) sur des rangées différentes.

4. Tête d'essai (10) selon la revendication 1, **caractérisée en ce que** ledit support de résine (13) comprend un contour formé supplémentaire (13a) qui se trouve positionné en correspondance audit dispositif (11) soumis à l'essai.

5. Tête d'essai (10) selon la revendication 4, **caractérisée en ce que** ledit contour formé supplémentaire (13a) du support de résine (13) est un contour à dents de scie, selon lequel les points d'émergence (15) desdites sondes (14), dudit support de résine (13), sont disposés sur un plan parallèle au plan contenant ledit dispositif (11) soumis à l'essai.

6. Tête d'essai (10) selon la revendication 5, **caractérisée en ce que** ledit contour supplémentaire (13a) fournit des sections (8) essentiellement identiques desdites sondes de contacte (14) qui font saillie du support de résine (13).

7. Tête d'essai (10) selon l'une quelconque des revendications 1 à 6, **caractérisée** en ce ladite tête d'essai comprend une pluralité de sondes de contacte (14) disposées en rangées pour tester une matrice en réseau de dispositifs, posés en série de rangées, chaque dispositif (11) dudit réseau étant mis en contacte par des rangées différentes desdites sondes de contacte (14).

8.  Tête d'essai (10) selon l'une quelconque des revendications 1 à 7 précédentes, **caractérisée en ce que** la dimension dudit support (13) est supérieure à celle de l'anneau de renforcement (12).

9.  Tête d'essai (10) selon la revendication 1, **caractérisée en ce qu'**une résine de calage de finition (20) sert à amalgamer ledit support de résine (13) et ledit anneau de renforcement (12).

FIG. 1
PRIOR ART

FIG. 2
PRIOR ART

8

*FIG. 3*
*PRIOR ART*

*FIG. 6A*
*PRIOR ART*

Side View

FIG. 4
PRIOR ART

Front View

FIG. 5A
PRIOR ART

FIG. 5B
PRIOR ART

FIG. 5C
PRIOR ART

EP 1 178 320 B1

FIG. 6C
PRIOR ART

FIG. 6B
PRIOR ART

EP 1 178 320 B1

FIG. 7A
PRIOR ART

FIG. 7B
PRIOR ART

12

FIG. 8A
PRIOR ART

FIG. 8B
PRIOR ART

FIG. 9

FIG. 10

FIG. 11

EP 1 178 320 B1